# EUROPEAN PATENT SPECIFICATION

(11) **EP 3 708 056 B1**
(45) Date of publication and mention of the grant of the patent: **26.04.2023**
(21) Application number: 20162520.9
(22) Date of filing: 11.03.2020
(51) Int. Cl.: A47K 13/30, H05B 3/00

(54) **HEATED TOILET SEAT**
HEIZBARER TOILETTSITZ
SIÈGE CHAUFFANT DE TOILETTES

(30) Priority: 11.03.2019 ES 201930220
(43) Date of publication of application: 16.09.2020
(73) Proprietor: Roca Sanitario, S. A., 08029 Barcelona (ES)
(72) Inventor: MUNAR SAURA, Miquel Angel, 08029 BARCELONA (ES)
(74) Representative: Ponti & Partners, S.L.P

(56) References cited:
- JP-A- 2002 141 158
- JP-A- 2005 253 646
- JP-A- 2010 075 533
- KR-A- 20170 143 075
- US-A1- 2015 231 698

## Description

### Field of the invention

The present invention relates to a heated toilet seat and a method for obtaining a resistive circuit made of electrically conducting paint to incorporate in said heated toilet seat.

### Background of the invention

The prior art contains numerous heated toilet seats. Polypropylene toilet seats have been mainly made by welding two parts (an upper face and a lower face) between which a wire-like electrical resistance is housed to provide the power required for heating. Also known are heated seats with a resin body that includes a resistive wire embedded in the seat, where the seat body is filled and painted to prevent the conducting wire from being visible.

For example, documents US 8,881,317 and WO2016020409 describe a seat heating system using a wiring structure.

Document JP2010075533 describes a toilet seat heating system in which an electrically conducting paint, instead of wiring, is applied directly on a thermoplastic resin sheet.

In addition, the heated toilet seats known in the prior art present highly varied electrical connection systems which tend to condition the design of the final part, as the connection is performed directly with a wire.

In view of the background art, the present inventors have developed an improved heated toilet seat that provides a compact appearance without the need for wiring, with uniform and controlled heating to a temperature between 25ºC and 35ºC, which also includes a connection system for the heated seat that allows quick assembly and removal (quick-release system).

### Description

A first aspect of the invention relates to a heated toilet seat according to claim 1 comprising a resin-based seat body wherein it comprises:
- a resistive circuit made of electrically conducting paint to heat the seat body, wherein said resistive circuit is printed on a paper sheet integrated, by pressing, in the resir base of said seat body; and
- connection means that connect electrically said resistive circuit made of conductive paint to an electrical power supply for providing electric power.

In the present invention, the printed circuit on the paper sheet is integrated, adhered or incorporated, by pressing, in the resin base of the seat body, which ensures an optimum heating efficiency in the seat body with an extremely compact and lightweight design.

In a preferred embodiment, the base resin for the seat body is a phenol-, urea- or melamine-based resin, preferably a phenol-base resin, more preferably a phenol-formaldehyde base resin, and most preferably, the resin has a phenol-formaldehyde content between 30% and 45% by weight with respect to total composition.

In a particularly preferable embodiment, the resin is a material known as Supralit^{®}, which has the following composition:
- 35-40% by weight of phenol-formaldehyde resin;
- 50-60% by weight of wood powder + mineral filler;
- 7-9% by weight of additives;
adjusting the amounts so that the components add up to 100%, and coated with a polyurethane acrylic enamel. This type of resin is particularly advantageous because it presents a higher quality and integrates the paper sheet in a highly compact manner.

In another preferred embodiment, the paper sheet used as a support for the resistive circuit has a melamine or vinyl base, preferably a melamine base.

In another preferred embodiment, the resistive circuit of electrically-conducting paint defines a conductive track with a length, width and thickness configured to provide a predetermined resistance value according to the desired heating temperature.

In another preferred embodiment, the resistive circuit of conducting paint comprises a metal-ion based conducting ink, preferably with silver ions, and optionally a graphite resistive ink.

In another preferred embodiment, the toilet seat comprises means for preventing overheating configured to prevent the temperature generated by the resistive circuit of conducting paint from exceeding a specified maximum temperature (Tmax). In this configuration, three preferred possible embodiments can be distinguished:
1) A configuration for the toilet seat wherein the means for preventing overheating comprise the resistive circuit of conducting paint, which consists in a PTC (Positive Temperature Coefficient) type paint that stabilises the specified maximum temperature (Tmax); or
2) A configuration for the toilet seat wherein the resistive circuit of conducting paint consists in a PTC type paint with a stabilisation temperature higher than the specified maximum temperature (Tmax), and wherein the means for preventing overheating comprise control means operatively connected to the resistive circuit of conducting paint and configured to:
   - measure the electric current circulating in the resistive circuit of conducting paint and, therefrom, calculate the current temperature (Ta) generated by the resistive circuit of conducting paint; and
   - control the voltage applied to the resistive circuit of conducting paint with said electrical power supply according to the current temperature (Ta) calculated; or
3) A configuration of the toilet seat wherein the resistive circuit of conducting paint is a main resistive circuit and wherein the overheating prevention means comprise:
   - an auxiliary resistive circuit of PTC conducting paint disposed in thermal contact with the seat body so that, as the temperature of the seat increases, the temperature of the auxiliary resistive circuit of PTC conducting paint also increases and consequently the resistance thereof; and
   - control means operatively connected to the auxiliary resistive circuit of conducting paint configured to:
      - detect the resistance thereof and, accordingly, calculate the current temperature (Ta) generated by the main resistive circuit; and
      - control the voltage applied to the main resistive circuit with the electrical power supply according to the current temperature (Ta) calculated.

In the context of the present invention, "Tmax" is understood to mean the temperature above which it is considered that the user will not be comfortable using the toilet seat.

In the context of the present invention, "stabilisation temperature" refers to the temperature reached by the PTC conducting paint according to the composition thereof.

According to a preferred embodiment, the connection means for electrically connecting the resistive circuit of conducting paint to an electrical power supply comprise electrical contacts arranged at the corresponding ends of the resistive circuit of conducting paint. These contacts include corresponding adapted electrical connectors for each one, allowing coupling, with ability to rotate, to an electrical connection shaft that defines the axis of rotation of the seat or is aligned with the axis of rotation of the seat.

Advantageously, the electrical connectors are configured as leaf springs that can be coupled removably to the electrical connection shaft that defines the axis of rotation of the seat, and preferably the connection means further comprise corresponding metal connection part between the ends of the circuit and the electrical connectors, said metal connection parts being integrated in the resin base of the seat body.

A second aspect of the present invention relates to a toilet comprising a toilet seat. Said toilet seat advantageously comprises a body on which the seat is mounted and at least an electrical connection shaft for the electrical connectors of the corresponding seat, said connection shaft forming part or being aligned with the rotation shaft of the seat. This electrical connection shaft includes a positive terminal and a negative terminal.

A third aspect of the invention relates to a method for obtaining a resistive circuit of conducting paint for use in a toilet seat, comprising the step of:
- printing a resistive circuit made of electrically-conducting paint on a paper sheet such that said resistive circuit defines a conducting track that is arranged in correspondence with the seat body.

This method allows advantageously obtaining a resistive circuit that is perfectly integrated in the seat body without any external element being seen, such as the wiring.

Preferably, the paper sheet used as a support for printing the resistive circuit of electrically-conducting paint has been previously punched and, advantageously, the paper sheet used as a support is melamine- or vinyl-based, and preferably melamine-based.

According to one embodiment, the resistive circuit made of conducting paint comprises a metal-ion based conducting ink, preferably with silver ions, and optionally a graphite resistive ink. Alternatively, to this embodiment, in another embodiment the resistive circuit of conducting paint comprises a PTC-type paint.

A fourth aspect of the present invention relates to a method for obtaining a toilet seat, comprising the steps of:
a) introducing the powdered base resin in a mould;
b) pressing the mould at a temperature between 150ºC and 190ºC to conform the base resin;
c) pressing again the mould to adhere the resistive circuit made of conducting paint on a sheet of paper obtained.

In a preferred embodiment, the base resin for step a) is a phenol-, urea- or melamine-based resin, preferably a phenol-base resin, more preferably a phenol-formaldehyde base resin, and most preferably a resin with a phenol-formaldehyde content between 30% and 45% by weight with respect to total composition. In a particularly preferable embodiment, the resin is a material known as Supralit^{®}, which has the following composition:
- 35-40% by weight of phenol-formaldehyde resin;
- 50-60% by weight of wood powder + mineral filler;
- 7-9% by weight of additives;
adjusting the amounts so that the components add up to 100%, and coated with a polyurethane acrylic enamel.

Advantageously the method also comprises the steps of:
d) eliminating burrs, and/or
e) painting the toilet seat the desired colour.

### Brief description of the drawings

For the better understanding of the description made herein, a set of drawings has been provided wherein, schematically and solely by way of a non-limiting example, an example of an embodiment for the heated toilet seat of the invention is represented.

In these drawings;
Figure 1 is a schematic representation of the formation of the heated toilet seat, which uses the resin-based seat body and the paper sheet on which the resistive circuit made of electrically-conducting paint is printed, to finally obtain a heated toilet seat that integrates the paint resistive circuit in the resin base.
Figure 2 is a schematic representation of a conductive track of the resistive circuit for electric current.
Figure 3 is a schematic representation of a first conductive track of a main resistive circuit made of conductive paint, and a second conductive track of an auxiliary resistive circuit made of PTC conductive pain, which is in thermal contact with the seat body.
Figure 4 is a perspective view that shows the part of the seat that includes the connection means that provide electrical connection of the resistive circuit made of conducting paint to an electrical power supply provided at an electrical connection shaft (not shown) which forms the axis of rotation of the seat.
Figure 5 is a perspective view of the portion of the seat of figure 4 that includes the connection means protected by a seat decorative piece.
Figure 6 shows a cross-section of the seat portion of figure 5.
Figure 7 is a perspective view that shows the part of the seat that includes the electrical connection means of figure 4 mounted rotatably about the electrical connection shaft that forms the axis of rotation of the seat.
Figure 8 is a perspective view that shows a cross-section of the seat portion that includes the electrical connection means coupled to the electrical connection shaft that forms part of the axis of rotation of the seat of figure 7.
Figure 9 is a perspective view of a portion of the heated toilet seat according to an embodiment in which the body of the seat made from a phenol-base resin, preferably a phenol-based resin of the material Supralit^{®}, integrates or incorporates by pressing a conductive paint circuit printed on a melamine paper sheet. For the sake of clarity, the seat of the figure is shown without a finishing paint layer, such as a layer of white paint meant to hide the circuit from view.

### Description of a preferred embodiment

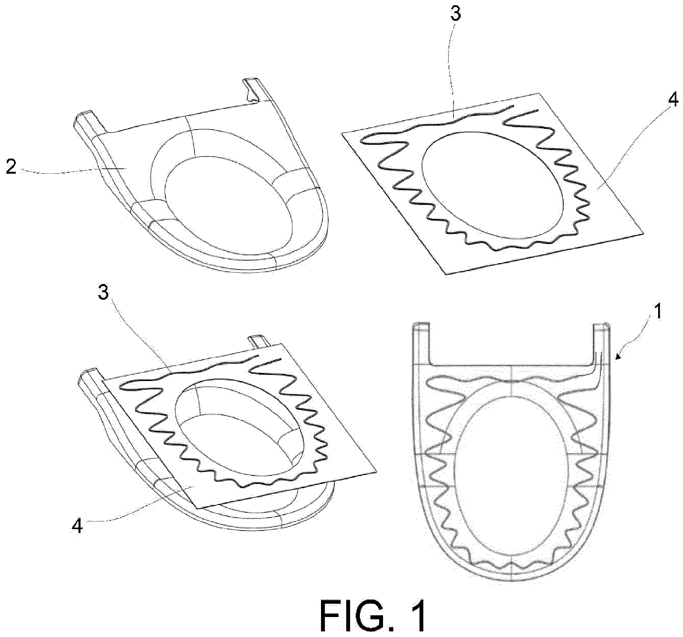

A preferred embodiment of the heated toilet seat of the present invention is described below with reference to figures 1 to 9.

The heated toilet seat 1 of the present invention comprises a resin-based seat body 2, preferably a body 2 made from a resin base of the brand Supralit ^{®}, inside which is integrated a paper sheet 4 that includes a printed resistive circuit 3 made of electrically-conducting paint. In the embodiment described, the sheet 4 on which the resistive circuit 3 is printed is made of melamine paper.

The resistive circuit 3 defines an electrically-conducting track with its ends arranged at a portion of the seat 1 that is coupled to an electrical connection shaft 9 that forms the axis of rotation of the seat 1.

As described in the description of the invention, the electrically conducting paint can consist, according to one embodiment, in a metal-ion base conducting ink, such as silver ions, and optionally include a graphite resistive ink. This type of paint has a specific resistance such that when a voltage is applied the temperature increases due to the current flowing in the circuit. In this embodiment, the temperature control of the seat is performed by adjusting the power supplied to the circuit to obtain the desired temperature.

According to another embodiment, the electrically conducting paint can consist in a PTC type paint that stabilises at the maximum temperature desired, for example at 30ºC, which allows increasing the power so that the seat 1 is heated more quickly while at the same time preventing overheating of the seat 1.

Optionally, in cases where a PTC type paint with a stabilisation temperature greater than the desired temperature is used, the use of control means (not shown) is considered for measuring the electrical current and thereby calculating the current temperature generated by the resistive circuit 3 made of PTC-type conducting paint. In this way it is possible to adjust the voltage applied to the resistive circuit 3 according to the current temperature calculated, to prevent overheating of the seat 1.

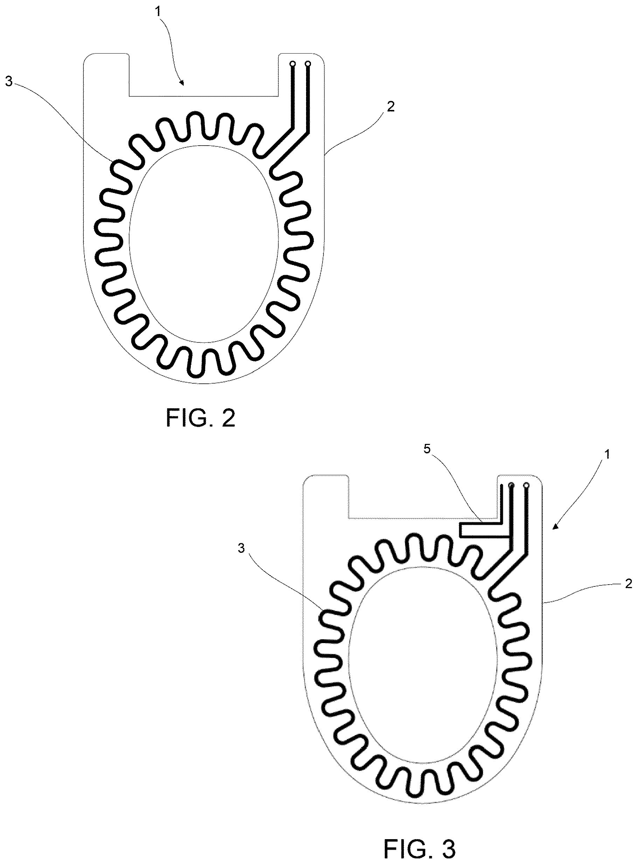

An alternative option to that described in the preceding paragraph, which also allows preventing overheating of the seat 1, consists in using an auxiliary resistive circuit 5 made of PTC-type conducting paint and control means (not shown) operatively connected to the auxiliary circuit 5 and configured to detect the resistance of the auxiliary circuit 5 and, therefrom, calculate the current temperature generated by the main resistive circuit 3. In this way it is possible to adjust the voltage applied to the main resistive circuit 3 according to the current temperature calculated, to prevent overheating of the seat 1. The auxiliary resistive circuit 5 is arranged in thermal contact with the body 2 of the seat 1 so that when the temperature of the body 2 increases, the temperature of the auxiliary circuit 5 increases. . This resistance is used by the control means to calculate the current temperature generated by the main resistive circuit 3 (see figure 3).

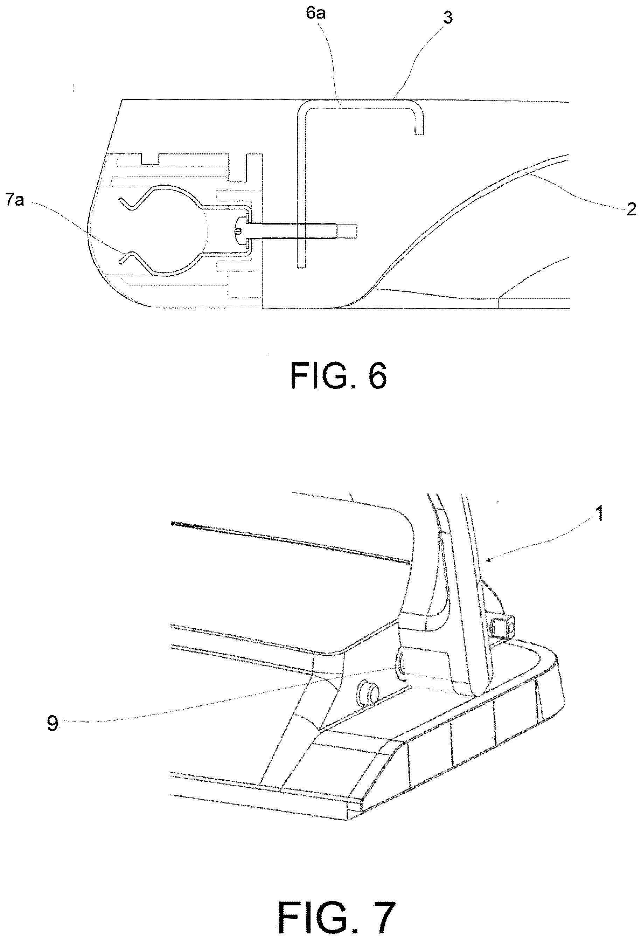

The seat 1 claimed presents the feature of including a seat portion comprising the connection means for electrical connection of the ends of the resistive circuit 3 made of conductive paint with an electrical connection shaft 9 that forms the axis of rotation of the seat 1. As can be seen in figure 7, the electrical connection shaft 9 through which energy is supplied to the resistive circuit 3 is arranged in a casing of the seat 1 that is coupled to the bowl (not shown) of the toilet.

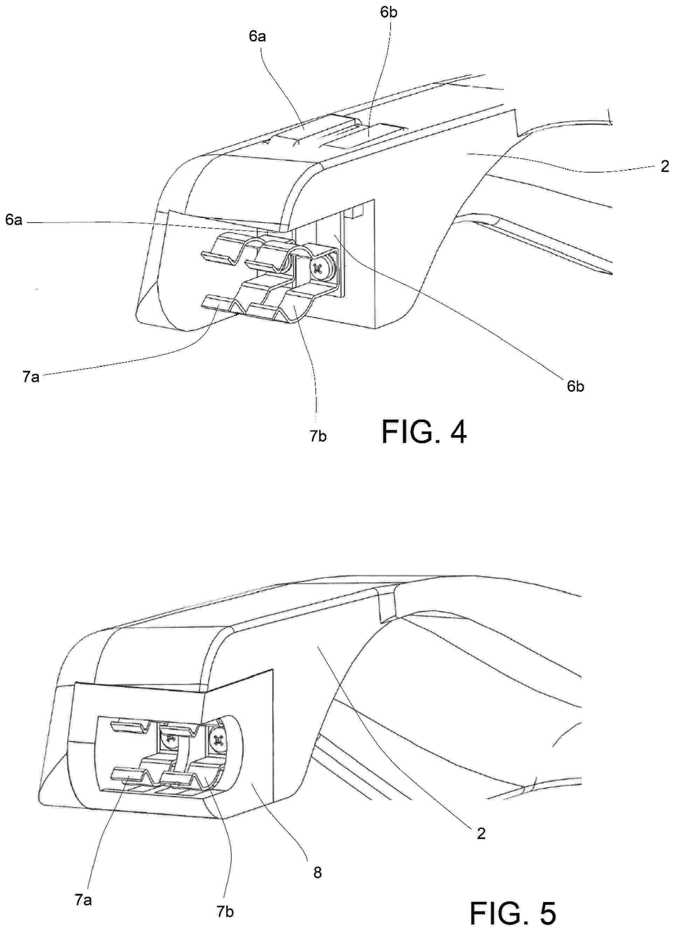

The electrical connection means comprise corresponding electrical contacts arranged on the ends of the resistive circuit 3 in contact with the conductive paint. Each of the contacts includes a metal part 6a, 6b for connection to a respective electrical connector 7a, 7b that is coupled to the electrical connection shaft 9. Figure 5 shows the electrical connection means protected by a decorative piece 8 that is coupled to the base body 2 of the seat 1.

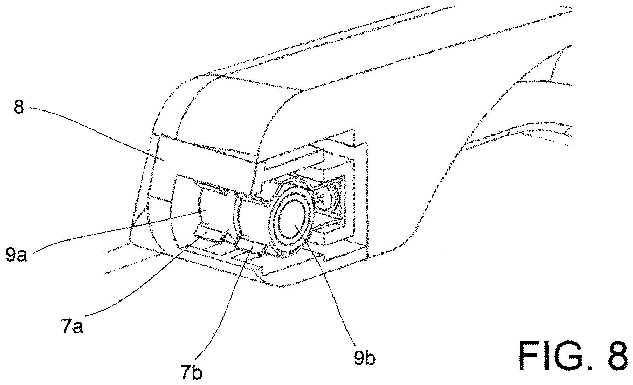

In the embodiment described the connectors 7a, 7b are configured in the manner of metal leaf springs that can be coupled removably to the positive and negative terminals 9a, 9b of the aforementioned electrical connection shaft (see figure 8). This system of leaf springs simplifies the quick assembly and removal (quick-release assembly) while providing an electrical connection with the advantage of not affecting the design of the seat 1.

With regard to the metal parts 6a, 6b of the connection means, these are integrated in the resin-based body 2 of the seat 1 and present a substantially L-shaped configuration arranged in contact with the resistive circuit 3 made of electrically conductive paint (see figure 6). These parts 6a, 6b are included in the body 2 of the seat during the moulding process.

An example is described below of the method for obtaining the resistive circuit made of conductive paint and the seat. In this example the resistive circuit 3 made of conductive paint is powered by a 12 V power supply.

Firstly, the powdered base resin (Supralit^{®}) is placed in a mould suitable for obtaining the toilet seat 1. Then a first pressing is performed at 170ºC to conform the material.

At the same time, a resistive circuit 3 is printed on a melamine paper sheet 4 by applying a silver-based conductive ink to define the electrically-conductive track.

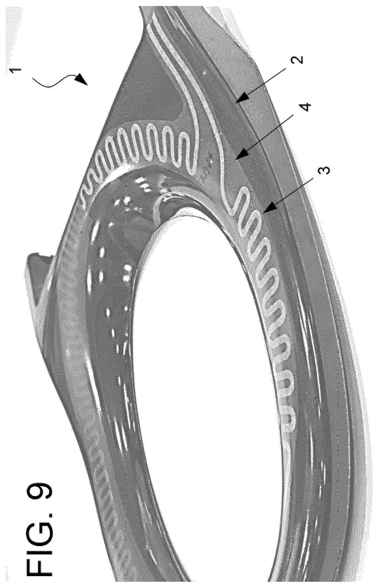

In a second phase the resistive circuit 3 painted on the melamine paper sheet 4 is incorporated in the seat body 2 by pressing. Previously the melamine paper sheet 4 is punched with the shape of the perimeter of the seat 1 (see figure 9).

It has been observed that the heating of the seat 1 produced by the electric current circulating in the resistive circuit 3 made of conducting paint takes place evenly in all the areas which can enter in contact with the user. The connections to the voltage source are such that they fit in the rotation point with the electrical connection shaft 9 that is in turn the rotation axis of the heated seat 1.

A person skilled in the art could make changes and modifications to the examples of embodiment described without going beyond the scope of the invention as defined in the attached claims.

## Claims

1. Heated toilet seat (1) comprising a resin-based seat body (2) and a resistive circuit (3) made of electrically conducting paint to heat the seat body (2), wherein said resistive circuit (3) is printed on a paper sheet (4), and said seat (1) comprises connection means (6a, 6b, 7a, 7b) that connect electrically the resistive circuit (3) made of conductive paint to an electrical power supply, wherein the heated toilet seat (1) is obtained by a process comprising the steps of;
a) introducing the powdered base resin in a mould;
b) pressing the mould at a temperature between 150ºC and 190ºC to conform the base resin of the seat body (2);
c) incorporating in the mould the printed resistive circuit (3) made of electrically conducting paint, where said resistive circuit (3) of conducting paint is printed on the paper sheet (4) such that it defines a conducting track susceptible of being arranged in correspondence with the conformed seat body (2); and
d) pressing the mould again to adhere or integrate by pressing the printed resistive circuit (3) made of conducting paint in the resin base of the seat body (2).

2. Toilet seat (1) according to claim 1, wherein said resin is a phenol-, urea- or melamine-based resin.

3. Toilet seat (1) according to claim 2, wherein said resin is a phenol-based resin and has the following composition:
- 35-40% by weight of phenol-formaldehyde resin;
- 50-60% by weight of wood powder + mineral filler;
- 7-9% by weight of additives;
adjusting the amounts so that the components add up to 100%, and coated with a polyurethane acrylic enamel.

4. Toilet seat (1) according to any of the preceding claims, wherein the paper sheet used as a support for printing the resistive circuit (3) is melamine or vinyl based.

5. Toilet seat (1), according to any of the preceding claims, wherein the resistive circuit (3) made of conducting paint defines a conducting track with a length, width and paint thickness configured to provide a predetermined resistance value according to the desired heating temperature, and wherein the printed resistive circuit of conducting paint comprises a metal-ion based conducting ink or graphite resistive ink

6. Toilet seat (1) according to any of claims 1 to 5, wherein it comprises means for preventing overheating configured to prevent the temperature generated by the resistive circuit (3) of conducting paint from exceeding a determined maximum temperature (Tmax).

7. Toilet seat (1) according to claim 6, wherein the means for preventing overheating comprise said resistive circuit (3) of conducting paint, which consists in a PTC (Positive Temperature Coefficient) type paint that stabilises the determined maximum temperature (Tmax).

8. Toilet seat (1) according to claim 6, wherein the resistive circuit made of conducting paint consists in a PTC-type paint with a stabilisation temperature higher than the determined maximum temperature (Tmax), and wherein the means for preventing overheating comprise control means operatively connected to the resistive circuit (3) of conducting paint, and configured to:
- measure the electric current circulating in the resistive circuit (3) made of conducting paint and, therefrom, calculate the current temperature (Ta) generated by the resistive circuit (3) of conducting paint; and
- control the voltage applied to the resistive circuit (3) made of conducting paint with said electrical power supply according to the current temperature (Ta) calculated.

9. Toilet seat (1) according to claim 6, wherein the resistive circuit (3) made of conducting paint is a main resistive circuit and wherein the overheating prevention means comprise:
- an auxiliary resistive circuit (5) made of PTC-type conducting paint disposed in thermal contact with the seat body (2) so that, as the temperature of the seat body (2) increases, the temperature of the auxiliary resistive circuit (5) of PTC-type conducting paint also increases and consequently the resistance thereof; and
- control means operatively connected to the auxiliary resistive circuit (5) made of conducting paint and configured to:
- detect the resistance of the auxiliary resistive circuit (5) and, therefrom, calculate the current temperature (Ta) generated by the main resistive circuit (3); and
- control the voltage applied to the main resistive circuit (3) with the electrical power supply according to the current temperature (Ta) calculated.

10. Toilet seat (1) according to any of the preceding claims, wherein the means for connection to the electric power supply comprise corresponding electrical contacts arranged at corresponding ends of the resistive circuit (3) made of conducting paint, wherein said contacts include corresponding electric connectors (7a, 7b), each one adapted to be rotatably coupled to an electrical connection shaft (9) that forms the axis of rotation of the seat (1).

11. Toilet seat (1) according to claim 10, wherein said electrical connectors (7a, 7b) are configured in the manner of leaf springs that can be coupled removably to the electrical connection shaft (9) that forms the axis of rotation of the seat (1).

12. Toilet seat (1) according to any of claims 10 to 11, wherein the electrical contacts of the connection means also comprise corresponding metallic connection parts (6a, 6b) for connection between the ends of the resistive circuit (3) and the electrical connectors (7a, 7b), and wherein said metallic connection parts (6a, 6b) are integrated in the resin base of the body (2) of the seat (1).

13. Toilet comprising a toilet seat (1) according to any of claims 1 to 12, and a body on which the seat (1) is mounted, said body including at least one electrical connection shaft (9) for the electrical connectors (7a, 7b) of the seat (1), aligned with the axis of rotation of the seat (1).

14. Method for obtaining a heated toilet seat (1) according to any of claims 1 to 12, which comprises the steps of:
a) introducing the powdered base resin in a mould;
b) pressing the mould at a temperature between 150ºC and 190ºC to conform the base resin of the seat body (2);
c) incorporating in the mould a resistive circuit (3) made of electrically conducting paint, where said resistive circuit (3) is obtained by printing a circuit of conducting paint on a paper sheet (4) such that it defines a conducting track susceptible of being arranged in correspondence with the seat body (2);
d) pressing the mould again to adhere or integrate the resistive circuit (3) made of conducting paint on the paper sheet (4) in the resin base of the seat body (2).

15. Method according to claim 14 where said resistive circuit (3) is obtained by printing the conducting paint circuit (3) on the paper sheet (4) which has been previously punched.

## Patentansprüche

1. Beheizter Toilettensitz (1), der einen Sitzkörper (2) auf Harzbasis und eine Widerstandsschaltung (3), die aus elektrisch leitender Farbe hergestellt ist, um den Sitzkörper (2) zu beheizen, umfasst, wobei die Widerstandsschaltung (3) auf ein Blatt (4) gedruckt ist, wobei der Sitz (1) Verbindungsmittel (6a, 6b, 7a, 7b) aufweist, die die aus leitender Farbe hergestellte Widerstandsschaltung (3) mit einer Stromversorgung elektrisch verbinden, wobei der beheizte Toilettensitz (1) durch einen Prozess erhalten wird, der die Schritte umfasst:
a) Einbringen des pulverisierten Basisharzes in eine Form,
b) Pressen der Form bei einer Temperatur zwischen 150 °C und 190 °C, um das Basisharz des Sitzkörpers (2) zu formen;
c) Einfügen in die Form der aus einer elektrisch leitenden Farbe hergestellten gedruckten Widerstandsschaltung (3), wobei die Widerstandsschaltung (3) aus leitender Farbe auf das Blatt (4) so gedruckt wird, dass sie einen leitenden Pfad definiert, der entsprechend dem geformten Sitzkörper (2) angeordnet werden kann; und
d) erneutes Pressen der Form, um die aus leitender Farbe hergestellte gedruckte Widerstandsschaltung (3) in der Harzbasis des Sitzkörpers (2) zu verkleben oder darin zu integrieren.

2. Toilettensitz (1) nach Anspruch 1, wobei das Harz ein Harz auf Phenol-, Harnstoff- oder Melaminbasis ist.

3. Toilettensitz (1) nach Anspruch 2, wobei das Harz ein Harz auf Phenolbasis ist und die folgende Zusammensetzung besitzt:
- 35-40 Gew.-% Phenol-Formaldehyd-Harz;
- 50-60 Gew.-% Holzpulver + mineralischer Füllstoff;
- 7-9 Gew.-% Additive;
wobei die Mengen so eingestellt sind, dass die Komponenten additiv 100 % ergeben, und mit einem Polyurethan-Acryl-Lack beschichtet sind.

4. Toilettensitz (1) nach einem der vorhergehenden Ansprüche, wobei das Blatt, das als Träger zum Drucken der Widerstandsschaltung (3) verwendet wird, Melamin- oder Vinyl-basiert ist.

5. Toilettensitz (1) nach einem der vorhergehenden Ansprüche, wobei die aus leitender Farbe hergestellte Widerstandsschaltung (3) einen leitenden Pfad mit einer Länge, Breite und Farbdicke definiert, die konfiguriert sind, entsprechend der gewünschten Heiztemperatur einen vorgegebenen Widerstandswert bereitzustellen, und wobei die gedruckte Widerstandsschaltung aus leitender Farbe eine leitende Metallionen-basierte Tinte oder eine resistive Graphittinte enthält.

6. Toilettensitz (1) nach einem der Ansprüche 1 bis 5, wobei dieser Mittel umfasst, die Überhitzen verhindern und konfiguriert sind zu verhindern, dass die durch die Widerstandsschaltung (3) aus leitender Farbe erzeugte Temperatur eine bestimmte Maximaltemperatur (Tmax) überschreitet.

7. Toilettensitz (1) nach Anspruch 6, wobei die Mittel zum Verhindern von Überhitzung die Widerstandsschaltung (3) aus leitender Farbe enthalten, die aus einer Farbe des PTC-Typs (Typ mit positivem Temperaturkoeffizienten) besteht, die die bestimmte Maximaltemperatur (Tmax) stabilisiert.

8. Toilettensitz (1) nach Anspruch 6, wobei die aus leitender Farbe hergestellte Widerstandsschaltung aus einer Farbe des PTC-Typs besteht, deren Stabilisierungstemperatur höher als die bestimmte Maximaltemperatur (Tmax) ist, und wobei die Mittel zum Verhindern von Überhitzung Steuermittel enthalten, die mit der Widerstandsschaltung (3) aus leitender Farbe betriebstechnisch verbunden sind und konfiguriert sind zum:
- Messen des elektrischen Stroms, der in der aus leitender Farbe hergestellten Widerstandsschaltung (3) fließt, und daraus Berechnen der aktuellen Temperatur (Ta), die durch die Widerstandsschaltung (3) aus leitender Farbe erzeugt wird, und
- Steuern der an die Widerstandsschaltung (3) aus leitender Farbe angelegten Spannung mit der Stromversorgung in Übereinstimmung mit der berechneten aktuellen Temperatur (Ta).

9. Toilettensitz (1) nach Anspruch 6, wobei die Widerstandsschaltung (3) aus leitender Farbe eine Widerstandshauptschaltung ist und wobei die Überhitzungsverhinderungsmittel umfassen:
- eine Widerstandshilfsschaltung (5), die aus leitender Farbe des PTC-Typs hergestellt ist, die in thermischem Kontakt mit dem Sitzkörper (2) angeordnet ist, so dass bei einem Anstieg der Temperatur des Sitzkörpers (2) die Temperatur der Widerstandshilfsschaltung (5) aus leitender Farbe des PTC-Typs ebenfalls ansteigt und folglich der Widerstand davon; und
- Steuermittel, die mit der Widerstandshilfsschaltung (5) aus leitender Farbe betriebstechnisch verbunden sind und konfiguriert sind zum:
- Detektieren des Widerstands der Widerstandshilfsschaltung (5) und daraus Berechnen der aktuellen Temperatur (Ta), die durch die Widerstandshauptschaltung (3) erzeugt wird, und
- Steuern der an die Widerstandshauptschaltung (3) angelegten Spannung mit der Stromversorgung in Übereinstimmung mit der berechneten aktuellen Temperatur (Ta).

10. Toilettensitz (1) nach einem der vorhergehenden Ansprüche, wobei die Mittel für Verbindung mit der Stromversorgung entsprechende elektrische Kontakte enthalten, die an entsprechenden Enden der aus leitender Farbe hergestellten Widerstandsschaltung (3) angeordnet sind, wobei die Kontakte entsprechende elektrische Verbinder (7a, 7b) aufweisen, wovon jeder so beschaffen ist, dass er mit einer elektrischen Verbindungswelle (9), die die Drehachse des Sitzes (1) bildet, drehbar gekoppelt ist.

11. Toilettensitz (1) nach Anspruch 10, wobei die elektrischen Verbinder (7a, 7b) in der Art von Blattfedern konfiguriert sind, die mit der elektrischen Verbindungswelle (9), die die Drehachse des Sitzes (1) bildet, lösbar gekoppelt werden können.

12. Toilettensitz (1) nach einem der Ansprüche 10 bis 11, wobei die elektrischen Kontakte der Verbindungsmittel auch entsprechende Metallverbindungsteile (6a, 6b) enthalten, um die Enden der Widerstandsschaltung (3) und die elektrischen Verbinder (7a, 7b) zu verbinden, und wobei die Metallverbindungsteile (6a, 6b) in die Harzbasis des Körpers (2) des Sitzes (1) integriert sind.

13. Toilette, die einen Toilettensitz (1) nach einem der Ansprüche 1 bis 12 und einen Körper, auf dem der Sitz (1) montiert ist, umfasst, wobei der Körper wenigstens eine elektrische Verbindungswelle (9) für die elektrischen Verbinder (7a, 7b) des Sitzes (1), die auf die Drehachse des Sitzes (1) ausgerichtet ist, aufweist.

14. Verfahren zum Erhalten eines beheizten Toilettensitzes (1) nach einem der Ansprüche 1 bis 12, das die Schritte umfasst:
a) Einbringen des pulverisierten Basisharzes in eine Form,
b) Pressen der Form bei einer Temperatur zwischen 150 °C und 190 °C, um das Basisharz des Sitzkörpers (2) zu formen;
c) Einfügen in die Form einer aus einer elektrisch leitenden Farbe hergestellten Widerstandsschaltung (3), wobei die Widerstandsschaltung (3) durch Drucken einer Schaltung aus leitender Farbe auf ein Blatt (4) erhalten wird, derart, dass sie einen leitenden Pfad definiert, der entsprechend dem Sitzkörper (2) angeordnet werden kann;
d) erneutes Pressen der Form, um die aus einer leitenden Farbe hergestellte Widerstandsschaltung (3) auf dem Blatt (4) in der Harzbasis des Sitzkörpers (2) zu verkleben oder darin zu integrieren.

15. Verfahren nach Anspruch 14, wobei die Widerstandsschaltung (3) durch Drucken der Schaltung (3) aus leitender Farbe auf das Blatt (4), das vorher gelocht worden ist, erhalten wird.

## Revendications

1. Siège de toilettes chauffant (1) comprenant un corps de siège à base de résine (2) et un circuit résistif (3) réalisé avec une peinture électriquement conductrice pour chauffer le corps de siège (2), dans lequel ledit circuit résistif (3) est imprimé sur une feuille de papier (4), et ledit siège (1) comprend des moyens de raccordement (6a, 6b, 7a, 7b) qui raccordent électriquement le circuit résistif (3) réalisé avec de la peinture conductrice, à une alimentation électrique, dans lequel :
le siège de toilettes chauffant (1) est obtenu avec un procédé comprenant les étapes consistant à :
a) introduire une résine de base en poudre dans un moule ;
b) presser le moule à une température comprise entre 150°C et 190°C pour conformer la résine de base du corps de siège (2) ;
c) incorporer dans le moule, le circuit imprimé résistif (3) réalisé avec une peinture électriquement conductrice, où ledit circuit résistif (3) de peinture conductrice est imprimé sur la feuille de papier (4) de sorte qu'il définit une piste conductrice susceptible d'être agencée en correspondance avec le corps de siège (2) conformé ; et
d) presser le moule à nouveau pour faire adhérer ou intégrer par pression, le circuit imprimé résistif (3) réalisé avec la peinture conductrice dans la base de résine du corps de siège (2).

2. Siège de toilettes (1) selon la revendication 1, dans lequel ladite résine est une résine à base de phénol, d'urée ou de mélamine.

3. Siège de toilettes (1) selon la revendication 2, dans lequel ladite résine est une résine à base de phénol et a la composition suivante :
35-40% en poids de résine phénol-formaldéhyde ;
50-60% en poids de poudre de bois + charge minérale ;
7-9% en poids d'additifs ;
ajuster les quantités de sorte que les composants s'ajoutent jusqu'à 100%, et sont recouverts avec une laque acrylique polyuréthane.

4. Siège de toilettes (1) selon l'une quelconque des revendications précédentes, dans lequel la feuille de papier utilisée en tant que support pour imprimer le circuit résistif (3) est à base de mélamine ou de vinyle.

5. Siège de toilettes (1) selon l'une quelconque des revendications précédentes, dans lequel le circuit résistif (3) réalisé avec de la peinture conductrice définit une piste conductrice avec une longueur, une largeur et une épaisseur de peinture configurée pour fournir une valeur de résistance prédéterminée selon la température de chauffage souhaitée, et dans lequel le circuit imprimé résistif de peinture conductrice comprend une encre conductrice à base d'ions métalliques ou une encre résistive au graphite.

6. Siège de toilettes (1) selon l'une quelconque des revendications 1 à 5, dans lequel il comprend des moyens pour empêcher la surchauffe configurés pour empêcher la température générée par le circuit résistif (3) de peinture conductrice d'excéder une température maximum (Tmax) déterminée.

7. Siège de toilettes (1) selon la revendication 6, dans lequel les moyens pour empêcher la surchauffe comprennent ledit circuit résistif (3) de peinture conductrice, qui se compose d'une peinture de type PTC (coefficient de température positif) qui stabilise la température maximum (Tmax) déterminée.

8. Siège de toilettes (1) selon la revendication 6, dans lequel le circuit résistif réalisé avec la peinture conductrice se compose d'une peinture de type PTC avec une température de stabilisation supérieure à la température maximum (Tmax) déterminée, et dans lequel les moyens pour empêcher la surchauffe comprennent des moyens de commande opérationnellement raccordés au circuit résistif (3) de peinture conductrice, et configurés pour :
mesurer le courant électrique circulant dans le circuit résistif (3) réalisé avec la peinture conductrice, et à partir de là, calculer la température actuelle (Ta) générée par le circuit résistif (3) de peinture conductrice ; et
commander la tension appliquée sur le circuit résistif (3) réalisé avec la peinture conductrice avec ladite alimentation électrique selon la température actuelle (Ta) calculée.

9. Siège de toilettes (1) selon la revendication 6, dans lequel le circuit résistif (3) réalisé avec la peinture conductrice est un circuit résistif principal et dans lequel les moyens de prévention de surchauffe comprennent :
un circuit résistif auxiliaire (5) réalisé avec une peinture conductrice de type PTC disposée en contact thermique avec le corps de siège (2) de sorte que, lorsque la température du corps de siège (2) augmente, la température du circuit résistif auxiliaire (5) de peinture conductrice de type PTC augmente également et par conséquent sa résistance ; et
des moyens de commande opérationnellement raccordés au circuit résistif auxiliaire (5) réalisé avec la peinture conductrice et configurés pour :
détecter la résistance du circuit résistif auxiliaire (5) et à partir de là, calculer la température actuelle (Ta) générée par le circuit résistif principal (3) ; et
commander la tension appliquée sur le circuit résistif principal (3) avec l'alimentation électrique selon la température actuelle (Ta) calculée.

10. Siège de toilettes (1) selon l'une quelconque des revendications précédentes, dans lequel les moyens pour le raccordement à l'alimentation électrique comprennent des contacts électriques correspondants agencés aux extrémités correspondantes du circuit résistif (3) réalisé avec la peinture conductrice, dans lequel lesdits contacts comprennent des connecteurs électriques (7a, 7b) correspondants, chacun adapté pour être couplé, en rotation, à un arbre de raccordement électrique (9) qui forme l'axe de rotation du siège (1).

11. Siège de toilettes (1) selon la revendication 10, dans lequel lesdits connecteurs électriques (7a, 7b) sont configurés à la manière des ressorts à lames qui peuvent être couplés de manière amovible à l'arbre de raccordement électrique (9) qui forme l'axe de rotation du siège (1).

12. Siège de toilettes (1) selon l'une quelconque des revendications 10 à 11, dans lequel les contacts électriques des moyens de raccordement comprennent également des parties de raccordement métalliques (6a, 6b) correspondantes pour le raccordement entre les extrémités du circuit résistif (3) et les connecteurs électriques (7a, 7b), et dans lequel lesdites parties de raccordement métalliques (6a, 6b) sont intégrées dans la base de résine du corps (2) du siège (1).

13. Toilettes comprenant un siège de toilettes (1) selon l'une quelconque des revendications 1 à 12, et un corps sur lequel le siège (1) est monté, ledit corps comprenant au moins un arbre de raccordement électrique (9) pour les connecteurs électriques (7a, 7b) du siège (1), aligné avec l'axe de rotation du siège (1).

14. Procédé pour obtenir un siège de toilettes chauffant (1) selon l'une quelconque des revendications 1 à 12, qui comprend les étapes consistant à :
a) introduire la résine de base en poudre dans un moule ;
b) presser le moule à une température comprise entre 150°C et 190°C pour conformer la résine de base du corps de siège (2) ;
c) incorporer dans le moule, un circuit résistif (3) réalisé avec de la peinture électriquement conductrice, où ledit circuit résistif (3) est obtenu en imprimant un circuit de peinture conductrice sur une feuille de papier (4) de sorte qu'il définit une piste conductrice susceptible d'être agencée en correspondance avec le corps de siège (2) ;
d) presser le moule à nouveau pour faire adhérer ou intégrer le circuit résistif (3) réalisé avec de la peinture conductrice sur la feuille de papier (4) dans la base de résine du corps de siège (2).

15. Procédé selon la revendication 14, dans lequel ledit circuit résistif (3) est obtenu en imprimant le circuit de peinture conductrice (3) sur la feuille de papier (4) qui a été précédemment frappé.
